# EUROPEAN PATENT APPLICATION

(11) **EP 3 038 229 A1**
(43) Date of publication of application: **29.06.2016**
(21) Application number: 15202227.3
(22) Date of filing: 22.12.2015
(51) Int. Cl.: H02J 7/00, G01R 31/36, H01M 10/48, H01M 10/44, H01M 10/42

(54) **STORAGE BATTERY, STORAGE-BATTERY EVALUATING DEVICE, AND STORAGE-BATTERY EVALUATING METHOD**

(30) Priority: 26.12.2014 JP 2014266179
(71) Applicant: Kabushiki Kaisha Toshiba, Tokyo (JP)
(72) Inventor: YAMAMOTO, Takahiro, Minato-ku, Tokyo (JP); HANYU, Yuki, Minato-ku, Tokyo (JP); ITAKURA, Akihiro, Minato-ku, Tokyo (JP); EZAWA, Toru, Minato-ku, Tokyo (JP)
(74) Representative: Noble, Nicholas

(57) **Abstract**

A storage battery includes power storage devices in series and switching circuits each arranged between adjacent power storage devices. Each switching circuit includes an input terminal I, an output terminal O, an input terminal Si, and an output terminal So, a first switch that electrically connects the input terminal Si and the output terminal O, a second switch that electrically connects the input terminal I and the output terminal So, a third switch that electrically connects the input terminal I and the output terminal O, and a fourth switch that electrically connects the input terminal Si and the output terminal So. The input terminal Si is electrically connected to the output terminal So of one of adjacent switching circuits and the output terminal So is electrically connected to the input terminal Si of the other of the adjacent switching circuits.

## Description

### FIELD

An embodiment described herein relates to a storage battery, a storage-battery evaluating device, and a storage-battery evaluating method.

### BACKGROUND

In electric vehicles and stationary battery systems, when used products are traded for secondary use or effective maintenance is performed, a technique for accurately and promptly evaluating the deterioration of the operating secondary batteries thereof has been demanded.

For example, to evaluate the deterioration of a secondary battery, a technique of estimating the performance of the secondary battery by analyzing the change in a charge/discharge curve that is precisely measured based on the material characteristics of the secondary battery has been considered.

Furthermore, for a secondary battery module constituted by a large number of battery cells, a technique of evaluating the performance of the entire module by analyzing and evaluating the change in a charge/discharge curve that is electrically synthesized has been also considered.

However, when the performance of the secondary battery module is deteriorated, it is difficult to determine whether all the battery cells are deteriorated substantially uniformly or the deterioration is caused by the influence of the characteristics of a small number of the battery cells the deterioration progresses of which have been advanced.

Similarly, when the performance of an entire battery string that is obtained by connecting a plurality of secondary battery modules in series is deteriorated, it is difficult to determine whether all the modules are deteriorated substantially uniformly or the deterioration is caused by the influence of the characteristics of a small number of the modules the deterioration progresses of which have been advanced.

### BRIEF DESCRIPTION OF THE DRAWINGS

FIG. 1 is a block diagram illustrating a power storage system according to an embodiment of the present invention;
FIG. 2 is a diagram illustrating a detailed configuration of a energy storage device;
FIG. 3 is a diagram illustrating a detailed configuration of a storage-battery evaluating device and a schematic configuration of the inside of a battery module;
FIG. 4 is a diagram illustrating a detailed configuration of a battery module;
FIG. 5 is a flowchart of deterioration evaluating operations performed by the storage-battery evaluating device; and
FIG. 6 is a diagram illustrating a configuration example of hardware of the storage-battery evaluating device according to an embodiment of the present invention.

### DETAILED DESCRIPTION

According to one embodiment, a storage battery including: a plurality of power storage devices that are arranged in series; and a plurality of switching circuits that are each arranged between adjacent power storage devices.

Each of the switching circuits includes
an input terminal I that is electrically connected to a first electrode side of one of adjacent power storage devices,
an output terminal O that is electrically connected to a second electrode side of the other of the adjacent power storage devices,
an input terminal Si,
an output terminal So,
a first switch that electrically connects the input terminal Si and the output terminal O,
a second switch that electrically connects the input terminal I and the output terminal So,
a third switch that electrically connects the input terminal I and the output terminal O, and
a fourth switch that electrically connects the input terminal Si and the output terminal So.

The input terminal Si is electrically connected to the output terminal So of the switching circuit adjacent via the one of the adjacent power storage devices and the output terminal So is electrically connected to the input terminal Si of the switching circuit adjacent via the other of the adjacent power storage devices.

Hereinafter, the detailed explanation will be described with the accompanying drawings.

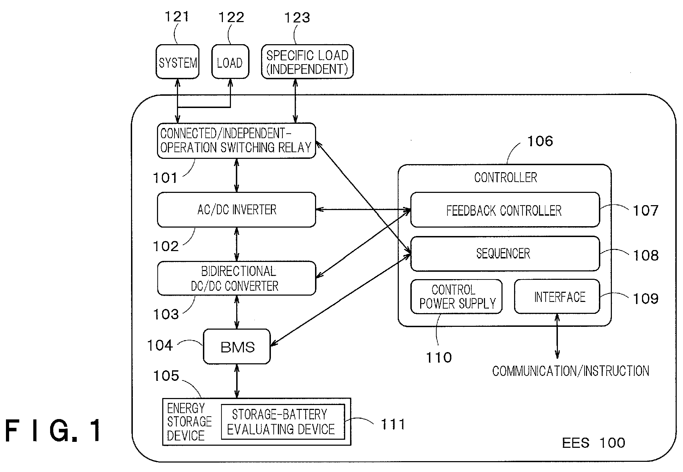

FIG. 1 is a block diagram illustrating a power storage system (ESS) according to an embodiment of the present invention.

An ESS 100 is connected to a power system (hereinafter, referred to as "system") 121. A load 122 is connected to the system. The ESS 100 performs charge/discharge (at least either charge or discharge) in accordance with an instruction from the system 121 so that power in the system 121 is leveled and the power quality is ensured. All or a part of power discharged from the ESS 100 may be supplied to the load 122 connected to the system. When the load 122 is a energy storage device, an inner energy storage device 105 may be charged by supply of power from the energy storage device. The ESS 100 may be separated from the system 121 and be connected to an independent specific load 123. In this case, the ESS 100 may charge/discharge the specific load 123.

A connected/independent-operation switching relay (hereinafter, referred to as "relay") 101 switches the connection destination of the ESS 100 between the system side and the specific-load side in accordance with an instruction from a controller 106.

A bidirectional AC/DC inverter 102 converts AC power supplied from the system side or the specific-load side to DC power and outputs the DC power to a bidirectional DC/DC converter 103. The bidirectional AC/DC inverter 102 converts DC power supplied from the inner energy storage device 105 via the bidirectional DC/DC converter 103 to AC power and outputs the AC power to the system side or the specific-load side via the relay 101. When the specific load 123 is driven by DC power, an inverter that converts AC power to DC power or DC power to AC power may be arranged at the specific-load side.

The bidirectional DC/DC converter 103 performs DC-DC conversion of the voltage of DC power supplied from the bidirectional AC/DC inverter 102 to generate constant voltage and outputs the power having the generated constant voltage to a battery management system (BMS) 104. The bidirectional DC/DC converter 103 converts the voltage of DC power supplied from the energy storage device 105 to voltage corresponding to the bidirectional AC/DC inverter 102 and outputs the power having the converted voltage to the bidirectional AC/DC inverter 102. The bidirectional DC/DC converter 103 may be omitted in some embodiments.

The BMS 104 is connected to the energy storage device 105 and performs charge/discharge control to the energy storage device 105 in accordance with an instruction from the controller 106. In the embodiment illustrated in FIG. 1, the BMS 104 is placed outside the energy storage device 105. However, the BMS 104 may be placed inside the energy storage device 105 in some embodiments.

The operations of the relay 101, the bidirectional AC/DC inverter 102, the bidirectional DC/DC converter 103, and the BMS 104, which are connected to the controller 106, are controlled by the controller 106.

The controller 106 includes a feedback controller 107, a sequencer 108, an interface 109, and a control power supply 110. The controller 106 is referred to as a PCS (Power Conditioning System) in some cases.

The control power supply 110 supplies operation power of the controller 106.

The interface 109 is a communication interface that performs wired or wireless communication with the outside via a communication network. The interface 109 communicates with an external device such as SCADA (Supervisory Control And Data Acquisition) to receive an instruction for charge/discharge. The interface 109 may transmit to an external device information about the operation state in the ESS 100, the state of electric power stored in the energy storage device 105, or the like.

The sequencer 108 converts the instruction for charge/discharge from the SCADA or the like to an operation instruction (a control sequence) for the BMS 104 and transmits the operation instruction to the BMS 104.

The feedback controller 107 performs control to stabilize the operations of the bidirectional AC/DC inverter 102 and the bidirectional DC/DC converter 103. For example, the feedback controller 107 performs control to stabilize the step-up/step-down operation of the bidirectional DC/DC converter 103. The feedback controller 107 performs control to stabilize the amplitude, the frequency, or the like of AC power generated by the bidirectional AC/DC inverter 102. The feedback controller 107 may receive information for specifying the specific contents of control from an external device such as SCADA and perform control based on the information.

The energy storage device 105 is a energy storage device that can charge/discharge electric power. The energy storage device 105 includes one or more arbitrary secondary batteries. Examples of the arbitrary secondary battery include a lithium ion battery, a lithium ion polymer battery, a lead storage battery, a nickel-cadmium battery, and a nickel-hydrogen battery. In the present embodiment, the energy storage device 105 is used for the ESS. However, the energy storage device 105 may be provided in other types of a device or system such as a portable electronic device and an electronic vehicle. The energy storage device 105 includes an evaluating device 111 that evaluates the deterioration of storage batteries. The evaluating device 111 may be arranged not inside the energy storage device 105 but outside the energy storage device 105 to be externally connected to the energy storage device 105.

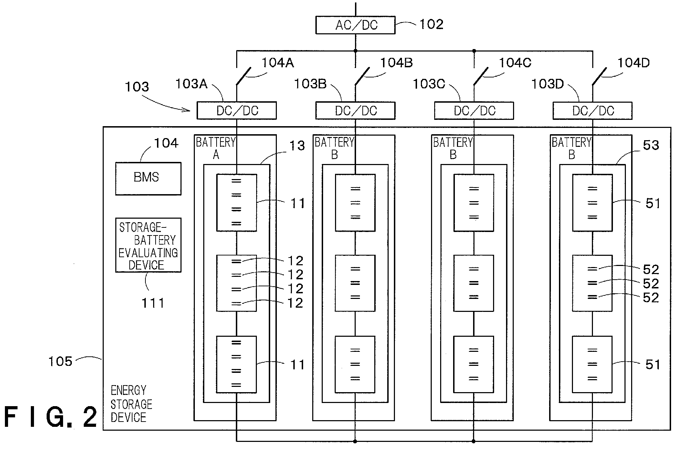

FIG. 2 illustrates a detailed configuration of a range from a bidirectional AC/DC inverter (that is expressed as "AC/DC" in FIG. 2) to a energy storage device. In this embodiment, the BMS 104 and the storage-battery evaluating device 111 are arranged inside the energy storage device 105. The energy storage device 105 includes one battery A and three batteries B. The battery A and the batteries B are connected to the bidirectional AC/DC inverter 102 via bidirectional DC/DC converters 103A, 103B, 103C, and 103D and switches 104A, 104B, 104C, and 104D, respectively. A set of the bidirectional DC/DC converters 103A, 103B, 103C, and 103D corresponds to the bidirectional DC/DC converter 103 illustrated in FIG. 1. The battery A includes a battery string 13 constituted by a plurality of battery modules 11 that are connected in series. Each of the battery modules 11 is constituted by a plurality of battery cells (hereinafter, referred to as "cell") 12 that are connected in series. In actuality, a switching circuit is interposed between the adjacent battery cells 12, as described later. Similarly, each of the three batteries B includes a battery string 53 constituted by a plurality of battery modules 51 that are connected in series. Each of the battery modules 51 is constituted by a plurality of cells 52 that are connected in series. In actuality, a switching circuit is interposed between the adjacent cells 52, as described later. Each of the cells and the power storage modules is an example of a power storage device that is a unit for measurement and evaluation according to the present embodiment.

The energy storage device 105 here includes two types of cells that are the cell A and the cells B. However, the energy storage device 105 may include only one type of cells or may include three or more types of cells. The battery A and the batteries B can be connected to and disconnected from the bidirectional AC/DC inverter by the switches 104A, 104B, 104C, and 104D, respectively. However, in some embodiment, the battery A and the batteries B may be fixedly connected to the bidirectional AC/DC inverter while omitting these switches. In other embodiments, the bidirectional DC/DC converters 103A to 103D may be omitted, as described above. The present embodiment has a characteristic in which the deterioration of the cells, the battery modules, or the batteries is evaluated by the outside, even when the energy storage device 105 is operating. For example, even when the switch 104A is in an on state, the deterioration of each cell 12 of the battery A is measured and evaluated by the outside.

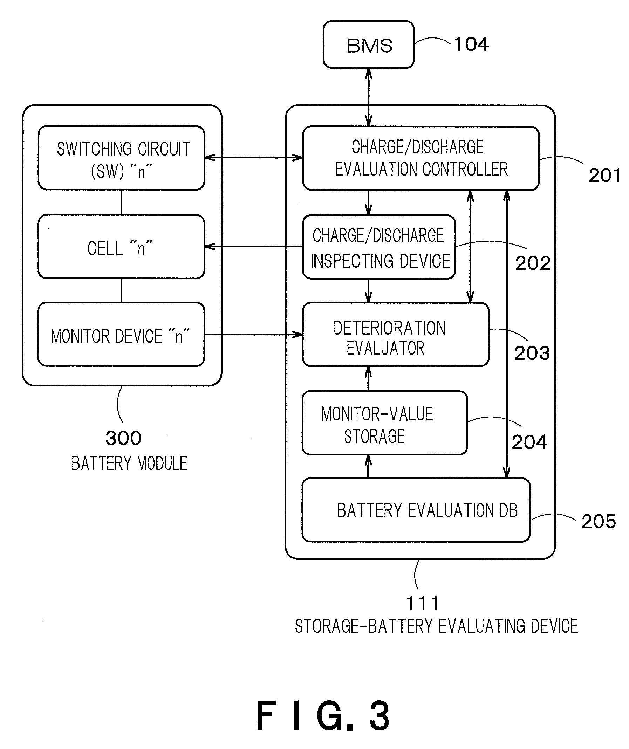

FIG. 3 illustrates the detailed configuration of the storage-battery evaluating device 111 and the schematic configuration of the inside of a battery module. A battery module 300 corresponds to the battery module 11 or 51 illustrated in FIG. 2, for example. Here, a case where the storage-battery evaluating device 111 evaluates the performances of the battery module 300 and individual cells in the battery module 300 is illustrated. In the battery module 300, a plurality of cells are arranged in series and the adjacent cells are connected via a switching circuit interposed therebetween. In each of the cells, a monitor device that measures parameters such as the voltage, current, and temperature of the cell is placed. The n-th switching circuit, the n-th cell, and the n-th monitor device are represented as "switching circuit 'n"', "cell 'n"', and "monitor device 'n"', respectively. The storage-battery evaluating device 111 may be provided for each energy storage device, for each battery string, or for each power storage module.

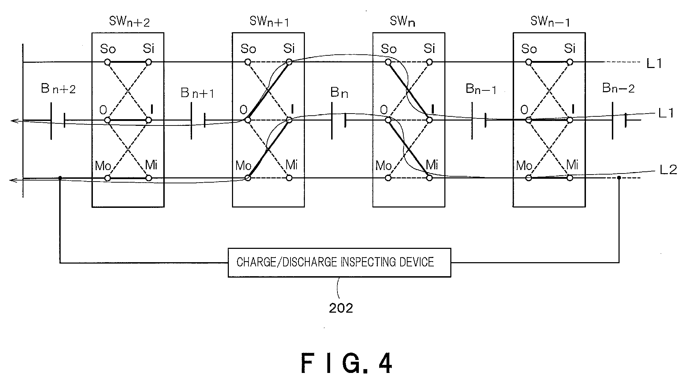

FIG. 4 illustrates the detailed configuration of a battery module. Illustrations of the monitor devices are omitted. Cells are represented by reference characters such as "Bn+2", "Bn+1", "Bn", "Bn-1", and "Bn-2". Switching circuits are represented by reference characters such as "SWn+2", "SWn+1", "SWn", and "SWn-1". The reference character "SWn" represents a switching circuit at the negative-electrode side of the cell Bn and the reference character "SWn+1" represents a switching circuit at a positive-electrode side of the cell Bn. A positive electrode corresponds to one electrode of a first electrode and a second electrode of a cell. A negative electrode corresponds to the other of the first electrode and the second electrode.

Each of the switching circuits includes an input terminal Si and an output terminal So, an input terminal I and an output terminal O, and an input terminal Mi and an output terminal Mo. The input terminal Si and the output terminal So are used to bypass an arbitrary cell in the series connection of the cells. The input terminal I and the output terminal O are used to connect adjacent cells to each other. The input terminal Mi and the output terminal Mo are used to set a route for connecting the arbitrary cell to a charge/discharge inspecting device 202. Each of the switching circuits includes seven switches for setting the connection among the terminals.

The output terminal So is connected to the input terminal Si and the input terminal I via respective switches. The output terminal O is connected to the input terminal Si, the input terminal I, and the input terminal Mi via respective switches. The output terminal Mo is connected to the input terminal I and the input terminal Mi via respective switches.

Broken lines and solid lines connecting the terminals in blocks, which represent the switching circuits, represent switches. The broken lines indicate switches that are off (open). The solid lines indicate switches that are on (closed). The positive electrode of a cell is connected to the input terminal I of the switching circuit at the positive electrode side of the cell. The negative electrode of a cell is connected to the output terminal O of the switching circuit at the negative electrode side of the cell. However, since no switching circuit is provided at the positive electrode side of the cell (Bn+2) that is the top of the positive electrode side and no switching circuit is provided at the negative electrode side of a cell that is the end of the negative electrode side, the above connections do not exist there.

The positive electrode of the cell (Bn+2) that is the top of the positive electrode side is electrically connected to the output terminal Mo of the switching circuit (SWn+2) at the negative electrode side of the cell (Bn+2). The negative electrode of the cell (B1) that is the end of the negative electrode side is electrically connected to the input terminal Mi of the switching circuit (SW2) at the positive electrode side of the cell (B1). The measuring terminals of the charge/discharge inspecting device 202 are connected respectively to the both ends of a row formed of the cells and switching circuits that are alternately arranged in series. More specifically, one of the measuring terminals is electrically connected to the positive electrode of the cell (Bn+2) that is the top of the positive electrode side and the output terminal Mo of the switching circuit (SWn+2) at the negative electrode side of the cell (Bn+2). The other of the measuring terminals is electrically connected to the negative electrode of the cell (B1) that is the end of the negative electrode side and the input terminal Mi of the switching circuit (SW2) at the positive electrode side of the cell (B1).

In this way, in the storage battery, by employing a plurality of switching circuits arranged between the adjacent cells, it is possible to selectively set any one of a plurality of patters to electrically separate each one of the plurality of cells connected in series from other cells of the plurality of cells excluding the one cell and electrically connect the other cells in series.

In FIG. 3, the storage-battery evaluating device 111 includes a charge/discharge evaluation controller 201, the charge/discharge inspecting device 202, a deterioration evaluator 203, a monitor-value storage 204, and a battery evaluation database (DB) 205. Under the control of the BMS 104, the storage-battery evaluating device 111 selects an arbitrary cell from among the plurality of cells in the battery module 300 as a target cell and measures and evaluates the target cell. The storage-battery evaluating device 111 measures and evaluates all the cells individually by switching cells to be selected sequentially. The performance of the battery module 300 is evaluated by aggregating the evaluation results of the cells.

The charge/discharge evaluation controller 201 selects a cell (a target cell) to be measured and evaluated and controls the switches in each switching circuit in such a way that the target cell is electrically separated from the other cells and the other cells are connected in series (in such a way that the both adjacent cells of the target cell are connected with each other by bypassing the target cell). The charge/discharge evaluation controller 201 controls the switches in each switching circuit in such a way that the target cell is connected to the charge/discharge inspecting device and the other cells are electrically separated from the charge/discharge inspecting device 202.

In the embodiment illustrated in FIG. 4, switch settings in the switching circuits when the cell Bn is selected will be described with reference to Table 1. Table 1 shows the connection state among the terminals in each switching circuit when the cell Bn is selected.

**[Table 1]**

| | | |
|---|---|---|
| SWn | Si -> OPEN | Status I |
| | I -> So | |
| | Mi -> O | |
| SWn+1 | Si -> O | Status B |
| | I -> Mo | |
| | Mi -> OPEN | |
| Othres | Si -> So | Status R |
| | I -> O | |
| | Mi -> Mo | |

That is, in the switching circuit (SWn) at the negative electrode side of the cell Bn, the switch between the input terminal Si and the output terminal So and the switch between the input terminal Si and the output terminal O are turned off (open) to open the input terminal Si. The switch between the input terminal I and the output terminal So is turned on (closed) to connect these terminals. The switch between the input terminal Mi and the output terminal O is turned on to connect these terminals. Both of the switch between the input terminal I and the output terminal O and the switch between the input terminal I and the output terminal Mo are turned off and the switch between the input terminal Mi and the output terminal Mo is turned off. The switch setting and connection state among the terminals as described above is referred to as "Status I".

In the switching circuit (SWn+1) at the positive electrode side of the cell Bn, the switch between the input terminal Si and the output terminal O is turned on to connect these terminals. The switch between the input terminal I and the output terminal Mo is turned on to connect these terminals. Both of the switch between the input terminal Mi and the output terminal O and the switch between the input terminal Mi and the output terminal Mo are turned off to open the input terminal Mi. The other switches than the above switches are all turned off. The switch setting and connection state among the terminals as described above is referred to as "Status B".

In each of the other switching circuits than the switching circuits (SWn and SWn+1), the switch between the input terminal Si and the output terminal So is turned on to connect these terminals (or the input terminal Si may be opened in some embodiments). The switch between the input terminal I and the output terminal O is turned on to connect these terminals. The switch between the input terminal Mi and the output terminal Mo is turned on to connect these terminals. The other switches than the above switches are all turned off. The switch setting and connection state among the terminals as described above is referred to as "Status R".

The above control of the switches in the switching circuits causes the cells excluding the cell Bn to be connected in series, as indicated by the line L1 in FIG. 4. Accordingly, the voltage of the battery module is decreased by voltage of one cell. The cell Bn that is electrically separated from the series connection is connected to the charge/discharge inspecting device 202, as indicated by the line L2 in FIG. 4. Accordingly, the cell Bn can be charged/discharged for measurement independently.

The charge/discharge inspecting device 202 charges/discharges (at least either charges or discharges) a target cell for measurement (see FIG. 3). The battery evaluation DB 205 stores measurement conditions such as a charge rate therein. The charge/discharge evaluation controller 201 instructs the charge/discharge inspecting device 202 to perform charge/discharge according to the measurement conditions. For example, after a target cell is discharged and the discharge is completed, the target cell is charged at a specified rate until the charge is completed. The charged amount of the target cell may be adjusted in such a way that the charged amount of the battery module 300 when the target cell is connected again after the charge/discharge for measurement is completed (that is, the total charged amount of all the cells when the target cell is connected again) comes to (for example, becomes equal to) the charged amount of the battery module 300 before the charge/discharge is started (that is, the total charged amount of all the cells before the target cell is separated). As described above, when the target cell is separated, it is recognized that the voltage of the battery module is decreased by voltage of one cell. However, this decrease can be absorbed by the voltage change of a cell the voltage of which monotonically increases relative to the charged amount or be absorbed by the DC/DC converter 103 that keeps the output voltage of the battery constant. When the output voltage of the battery is kept constant by the DC/DC converter 103, the charged amount of the target cell is made to be equal to or comes to the value before the charge/discharge for measurement is started (the value of the charged amount at a time when the target cell is separated). Accordingly, the charged amount of the battery module 300 can be made to return to or comes to the charged amount before the charge/discharge is started. When the above decrease is absorbed by the voltage change of a cell the voltage of which monotonically increases relative to the charged amount, the target cell may be charged (or discharged) by a charge amount that corresponds to the difference between a charge amount corresponding to the voltage change and the charged amount of the target cell before the charge/discharge for measurement is started. Adjustment of the charged amount of the target cell may be performed even after the deterioration evaluator 203 evaluates the deterioration of the target cell.

The deterioration evaluator 203 acquires measurement data (such as current, voltage, power, and a temperature) that is obtained by measuring the target cell at a fixed sampling rate during the charge/discharge and stores the acquired measurement data in the monitor-value storage 204 (see FIG. 3). After the charge/discharge is completed, the deterioration evaluator 203 evaluates the deterioration of the target cell based on the measurement data stored in the monitor-value storage 204 and the battery evaluation DB 205.

For example, the deterioration evaluator 203 generates a charge/discharge curve (also referred to as "QV curve") from the acquired measurement data group and calculates a feature amount from the generated charge/discharge curve or a curve (a dQdV curve) that is obtained by differentiating the charge/discharge curve by using a calculation algorithm that is determined in advance. Data (such as a function and a table) associating the feature amount and the performance (such as the capacity value and the internal resistance value) of a cell is stored in the battery evaluation DB 205. The deterioration evaluator 203 calculates the cell performance from the data in the battery evaluation DB 205 by using the calculated feature amount. The deterioration evaluator 203 also sequentially selects the other cells, charges/discharges, measures, and evaluates the cells to calculate the performance of each cell. Alternatively, the deterioration evaluator 203 may apply a different estimating method. For example, the deterioration evaluator 203 calculates the internal resistance value of the target cell, generates measurement data including temperature-time distribution and current-time distribution and a deterioration characteristic map indicating the distribution of deterioration constant relative to the cell voltage and the temperature, and integrates the staying time on a cell voltage-temperature plane of the deterioration characteristic map. In this way, the deterioration evaluator 203 may estimate the deterioration amount of the target cell (Japanese Patent Laid-Open No. 2014-190763).

The deterioration evaluator 203 calculates the performance value of the battery module from the performance values of the cells that are calculated in the above way and returns the evaluation result based on the calculated performance value to the BMS via the charge/discharge evaluation controller 201. For example, the deterioration evaluator 203 may determine the worst value of the performance values of the cells as the evaluation result of the battery module or determine the statistic value such as the average value as the performance value of the battery module. Alternatively, the deterioration evaluator 203 may calculate the residual life of the battery module based on the data of the relation between performance values and residual lives and return the calculated residual life as the evaluation result. The deterioration evaluator 203 may return the evaluation result based on the performance value of each cell to the BMS via the charge/discharge evaluation controller 201. The evaluation result may be a performance value as it is or may be the residual life of a cell calculated from the evaluation result. The above methods of calculating the performances of the cells and the battery module are some examples among many. Any other calculating method can be applied as long as the respective performances are calculated from measurement data. For example, a value that is obtained by multiplying the feature amount calculated by the deterioration evaluator 203 by a fixed coefficient may be determined as the performance value of the cell.

To switch a target cell from Bn to Bn+1, it suffices that the status of each switching circuit is controlled in the following way. As shown in Table 1, when the cell Bn is selected, SWb, SWb+1, and the others are in the status I, the status B, and the status R, respectively. When the cell Bn is switched to the cell Bn+1, SWn+1, SWn+2, and the others enter the status I, the status B, and the status R, respectively. Accordingly, the cell Bn+1 is electrically separated from the battery module and the battery module excluding the cell Bn+1 starts to function. However, when the cell Bn+2 is selected in the embodiment in FIG. 4, SWn+3 does not exist. Similarly, when a cell 1 (the lowest numbered cell) is selected, SW1 does not exist. Thus, the settings of SWn+3 and SW1 are not performed.

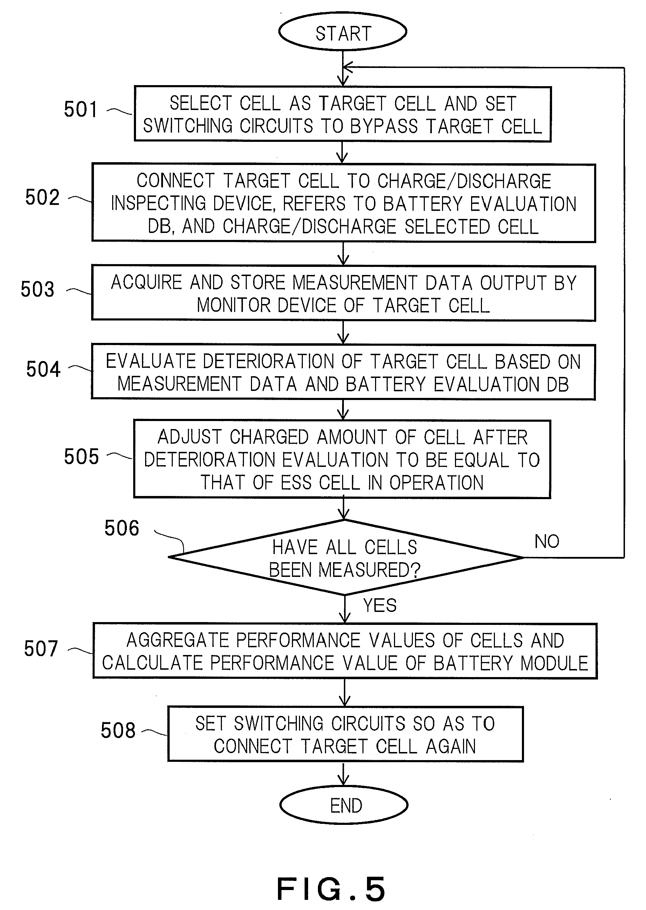

FIG. 5 is a flowchart of the deterioration evaluating operations of the storage-battery evaluating device. The charge/discharge evaluation controller 201 determines the start of the deterioration evaluating operations by an arbitrary trigger. The arbitrary trigger may be the reception of a start instruction from the BMS, a constant time period, arrival of preset times, or other criteria. At the start of the operations, since all the switching circuits in the battery module are set to the status R, all the cells are connected in series. It is assumed that the battery module is connected to the AC/DC inverter side and is in operation.

### (Step 501)

When the charge/discharge evaluation controller 201 determines to start operations, the charge/discharge evaluation controller 201 selects one cell as a target cell and connects the other cells in series to bypass the target cell. That is, the switches in each switching circuit are set so as to achieve the above connection.

### (Step 502)

The charge/discharge evaluation controller 201 electrically connects the target cell to the chare/discharge inspecting device. More specifically, the switches in each switching circuit are set so as to electrically connect only the target cell to the chare/discharge inspecting device. This setting may be performed at Step 501. The charge/discharge inspecting device 202 charges/discharges the target cell. The charge/discharge evaluation controller 201 specifies a charging/discharging condition such as a charging rate based on the battery evaluation DB 205 and instructs the charge/discharge inspecting device 202 about the condition.

### (Step 503)

The deterioration evaluator 203 sequentially acquires measurement data that is output at a fixed sampling rate from the monitor device arranged corresponding to the target cell. For example, the measurement data includes information about voltage, the cell temperature, or the like. The acquired measurement data is stored in the monitor-value storage 204.

### (Step 504)

The deterioration evaluator 203 obtains the performance value (such as the capacity value and the internal resistance value) of a cell by evaluating the deterioration of the cell based on the measurement data stored in the monitor-value storage 204 and the battery evaluation DB 205.

### (Step 505)

After the charge/discharge for measurement of the target cell is completed, the charge/discharge inspecting device 202 adjusts the charged amount of the target cell after the deterioration evaluation so as to make the charged amount equal to that of an ESS cell (the battery module 300) that is being operated.

### (Step 506)

The charge/discharge evaluation controller 201 determines whether all the cells in the battery module have been measured. When a cell having not been measured exists (NO at Step 506), the operation returns to Step 501 and a next cell is selected.

### (Step 507)

When all the cells in the battery module have been measured (YES at Step 506), the charge/discharge evaluation controller 201 obtains the performance value of the battery module by aggregating the performance values of the cells. The charge/discharge evaluation controller 201 outputs an evaluation result based on the performance value of the battery module. Alternatively, the charge/discharge evaluation controller 201 may output an evaluation result for each cell based on the performance value thereof.

### (Step 508)

The charge/discharge evaluation controller 201 sets the switches in each switching circuit in such a way that the target cell is finally connected to the battery module again at Step 508. More specifically, the charge/discharge evaluation controller 201 sets all the switching circuits to the status R. Accordingly, all the cells in the battery module are connected in series.

In the present embodiment, a cell to be measured is sequentially switched while targeting the cells in the battery module. However, the unit for measurement may be not a cell but a power storage module. For example, in some embodiments, switching circuits are arranged among battery modules and measurement is performed by switching a battery module to be measured sequentially while targeting the battery modules in a battery string. In this case, measurement and performance evaluation are performed in battery-module unit and the evaluated performances of the battery modules are aggregated. Accordingly, the performance of the battery string can be evaluated.

In the present embodiment, each switching circuit includes the input terminal Mi and the output terminal Mo and the measuring terminals of the charge/discharge inspecting device are connected respectively to the both ends of the row formed of the cells and the switching circuits that are arranged alternately in series (see FIG. 4). However, different configurations may be applied in some embodiments. For example, measurement terminals for each cell are connected to the positive electrode and the negative electrode of the cell. Only the target cell is electrically connected to the charge/discharge inspecting device by switch control in the charge/discharge inspecting device, and the other cells are separated from the charge/discharge inspecting device by turning the switches off. According to this configuration, the input terminals Mi and the output terminals Mo are unnecessary for the switching circuits and the switches between the respective input terminals Mi and the respective output terminals Mo, the switches between the respective output terminals Mo and the respective input terminals I, and the switches between the respective input terminals Mi and the respective output terminals O can be also omitted. However, many electric wirings for connecting the charge/discharge inspecting device and cells are required and a switch and a switch controller are required for the charge/discharge inspecting device.

As described above, according to the present embodiment, in the electric power storage module in which cells are connected in series, the electric power storage modules in operation can be evaluated from the outside. That is, the switching circuits are interposed among the cells connected in series and an arbitrary cell in the battery module is separated from the series connection of the cells by settings of the switching circuits. Cells before and after the separated cell are reconnected by settings of the switching circuits to bypass the separated cell. The separated cell can be electrically connected to the outside of the battery module freely. Thus, by independently connecting to the charge/discharge inspecting device, the separated cell can be charged/discharged for measurement and the deterioration of the separated cell can be evaluated.

At that time, owing to the separation of the cell, the voltage of the battery module is decreased by the voltage of one cell, and when the number of the cells is "h", the decreased voltage is "1/h". This decrease can be absorbed by the voltage change of a cell the voltage of which monotonically increases relative to the charged amount or by the DC/DC converter 103 that keeps the output voltage of the battery constant. Therefore, even when one cell is electrically separated from the battery module for measurement, the functions and performance of the battery module can be held equal to that before the separation.

Similarly, when the unit for measurement and evaluation is not a cell but a battery module, switching circuits are interposed among all battery modules connected in series so that an arbitrary battery module can be separated from the series connection of the battery modules by settings of the switching circuits. The separated battery module can be electrically connected to the outside of the battery module freely. Thus, the separated battery module independently connects to the charge/discharge inspecting device so that the separated battery module can be charged/discharged for measurement and the deterioration of the separated battery module can be evaluated. When a battery module is separated, the voltage decreases by voltage of one battery module. However, as in the above case, this voltage decrease can be absorbed by the DC/DC converter 103 that keeps the output voltage of the battery constant or the like. Therefore, even when one battery module is electrically separated from a battery string for measurement, the functions and performance of the battery string can be held equal to that before the separation.

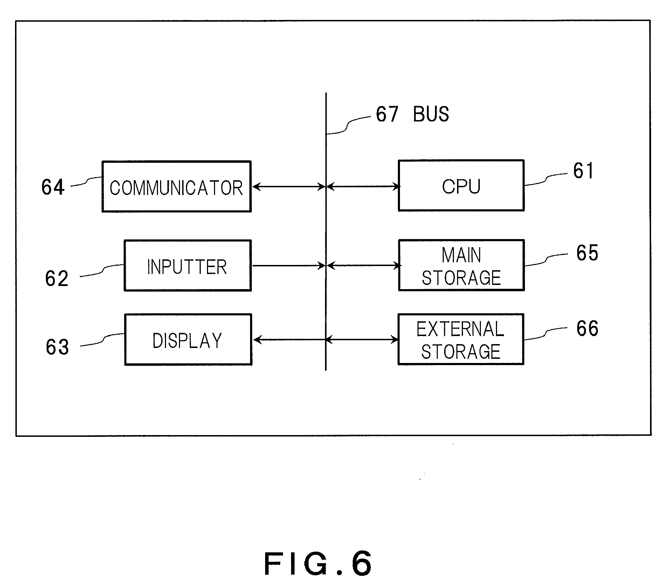

FIG. 6 illustrates a configuration example of hardware of a storage-battery evaluating device according to an embodiment of the present invention. The storage-battery evaluating device can be provided by the hardware configuration illustrated in FIG. 6. The storage-battery evaluating device in FIG. 6 includes a CPU 61, an inputter 62, a display 63, a communicator 64, a main storage 65, and an external storage 66, which are connected by a bus 67 in such a way that mutual communication thereamong can be performed.

The inputter 62 includes an input device such as a keyboard and a mouse. The display 63 includes a display such as an LCD (Liquid Crystal Display) and a CRT (Cathode Ray Tube). The communicator 64 includes wireless or wired communicating means and performs communication by a predetermined communication method.

The external storage 66 includes a storage medium such as an HDD, an SSD, a memory device, a CD-R, a CD-RW, a DVD-RAM, and a DVD-R. In the external storage 66, a program for causing the CPU 61 to execute the functions of the respective processing units in FIG. 3 is stored. The monitor-value storage 204 and the battery evaluation DB 205 are also included in the external storage 66. In FIG. 6, only one external storage 66 is illustrated. However, a plurality of the external storages 66 may be provided.

The main storage 65 develops a control program stored in the external storage 66 under the control of the CPU 61 and stores data required for executing the program, data generated by execution of the program, and the like therein. The main storage 65 includes an arbitrary memory or storage such as a volatile memory (such as a DRAM and a SRAM) or a non-volatile memory (such as a NAND flush memory and a MRAM). The control program developed by the main storage 65 may be executed by the CPU 61 to perform the functions of the charge/discharge evaluation controller 201, the charge/discharge inspecting device 202, and the deterioration evaluator 203.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A storage battery comprising:
a plurality of power storage devices that are arranged in series; and
a plurality of switching circuits that are each arranged between adjacent power storage devices, wherein
each of the switching circuits includes
an input terminal I that is electrically connected to a first electrode side of one of adjacent power storage devices,
an output terminal O that is electrically connected to a second electrode side of the other of the adjacent power storage devices,
an input terminal Si,
an output terminal So,
a first switch that electrically connects the input terminal Si and the output terminal O,
a second switch that electrically connects the input terminal I and the output terminal So,
a third switch that electrically connects the input terminal I and the output terminal O, and
a fourth switch that electrically connects the input terminal Si and the output terminal So, and
the input terminal Si is electrically connected to the output terminal So of the switching circuit adjacent via the one of the adjacent power storage devices and the output terminal So is electrically connected to the input terminal Si of the switching circuit adjacent via the other of the adjacent power storage devices.

2. The storage battery according to claim 1, wherein
each of the switching circuits further includes
an input terminal Mi,
an output terminal Mo,
a fifth switch that electrically connects the input terminal Mi and the output terminal O,
a sixth switch that electrically connects the input terminal I and the output terminal Mo, and
a seventh switch that electrically connects the input terminal Mi and the output terminal Mo, and
the input terminal Mi is electrically connected to the output terminal Mo of the switching circuit adjacent via the one of the adjacent power storage devices and the output terminal Mo is connected to the input terminal Mi of the switching circuit adjacent via the other of the adjacent power storage devices.

3. A storage-battery evaluating device for the storage battery according to claim 1, the device comprising
a charge/discharge evaluation controller that selects a target power storage device that is one of the plurality of power storage devices and sets switches of each switching circuit in such a way that other power storage devices of the plurality of power storage devices excluding the target power storage device are electrically connected in series and the target power storage device is electrically separated from the other power storage devices connected in series.

4. The storage-battery evaluating device according to claim 3, further comprising a deterioration evaluator, wherein
the charge/discharge evaluation controller controls a charge/discharge inspecting device connected to the target power storage device to charge/discharge the target power storage device for measurement, and
the deterioration evaluator acquires measurement data obtained by measuring the target power storage device during the charge/discharge.

5. The storage-battery evaluating device according to claim 4, wherein the deterioration evaluator evaluates deterioration of the target power storage device based on the measurement data.

6. The storage-battery evaluating device according to claim 4 or 5, wherein when the target power storage device is connected again after the charge/discharge of the target power storage device is completed, the charge/discharge evaluation controller adjusts a charged amount of the target power storage device in such a way that a total of charged amounts of the plurality of power storage devices after the target power storage device is connected again comes to a total of charged amounts of the plurality of power storage devices before the target power storage device is separated.

7. A storage-battery evaluating device for the storage battery according to claim 2, the device comprising
a charge/discharge evaluation controller that
selects a target power storage device that is one of the plurality of power storage devices and sets first to fourth switches of each switching circuit in such a way that other power storage devices of the plurality of power storage devices excluding the target power storage device are electrically connected in series and the target power storage device is electrically separated from the other power storage devices connected in series, and
sets fifth to seventh switches of each switching circuit in such a way that the input terminal Mi and the output terminal O are electrically connected in a first of the switching circuits that connects the output terminal O to the target power storage device, the input terminal I and the output terminal Mo are electrically connected in a second of the switching circuits that connects the input terminal I to the target power storage device, and the input terminal Mi and the output terminal Mo are electrically connected in each of the switching circuits excluding the first and the second of the switching circuits.

8. The storage-battery evaluating device according to claim 7, further comprising a charge/discharge inspecting device that is electrically connected to both ends of the plurality of power storage devices arranged in series.

9. The storage-battery evaluating device according to claim 8, further comprising a deterioration evaluator, wherein
the charge/discharge evaluation controller controls the charge/discharge inspecting device to charge/discharge the target power storage device for measurement, and
the deterioration evaluator acquires measurement data obtained by measuring the target power storage device during the charge/discharge.

10. The storage-battery evaluating device according to claim 9, wherein the deterioration evaluator evaluates deterioration of the target power storage device based on the measurement data.

11. The storage-battery evaluating device according to claim 9 or 10, wherein when the target power storage device is connected again after the charge/discharge of the target power storage device is completed, the charge/discharge evaluation controller adjusts a charged amount of the target power storage device in such a way that a total of charged amounts of the plurality of power storage devices after the target power storage device is connected again comes to a total of charged amounts of the plurality of power storage devices before the target power storage device is separated.

12. The storage-battery evaluating device according to any one of claims 3 to 11, wherein
the power storage device is a battery cell or a battery module.

13. A storage-battery evaluating method for the storage battery according to claim 1, the method comprising:
selecting a target power storage device that is one of the plurality of power storage devices in the storage battery: and
setting switches of each switching circuit in such a way that other power storage devices of the plurality of power storage devices excluding the target power storage device are electrically connected in series and the target power storage device is electrically separated from the other power storage devices connected in series.

14. A storage-battery evaluating method for the storage battery according to claim 2, the method comprising
selecting a target power storage device that is one of the plurality of power storage devices:
setting first to fourth switches of each switching circuit in such a way that other power storage devices of the plurality of power storage devices excluding the target power storage device are electrically connected in series and the target power storage device is electrically separated from the other power storage devices connected in series: and
setting fifth to seventh switches of each switching circuit in such a way that the input terminal Mi and the output terminal O are electrically connected in a first of the switching circuits that connects the output terminal O to the target power storage device, the input terminal I and the output terminal Mo are electrically connected in a second of the switching circuits that connects the input terminal I to the target power storage device, and the input terminal Mi and the output terminal Mo are electrically connected in each of the switching circuits excluding the first and the second of the switching circuits.

15. A storage-battery evaluating device for a storage battery, the storage battery comprising a plurality of switching circuits that selectively sets one of a plurality of patters to each electrically separate one of a plurality of power storage devices connected in series from other power storage devices of the plurality of power storage devices excluding the one power storage device and electrically connect the other power storage devices in series, the storage-battery evaluating device comprising:
a charge/discharge evaluation controller that selects a target power storage device that is one of the plurality of power storage devices and sets the switching circuits in such a way that other power storage devices of the plurality of power storage devices excluding the target power storage device are electrically connected in series and the target power storage device is electrically separated from the other power storage devices connected in series, and controls a charge/discharge inspecting device connected to the target power storage device to charge/discharge the target power storage device for measurement; and
a deterioration evaluator to acquire measurement data obtained by measuring the target power storage device during the charge/discharge and evaluate deterioration of the target power storage device based on the measurement data.

16. A storage-battery evaluating method for a storage battery, the storage battery comprising a plurality of switching circuits that selectively sets one of a plurality of patters to each electrically separate one of a plurality of power storage devices connected in series from other power storage devices of the plurality of power storage devices excluding the one power storage device and electrically connect the other power storage devices in series, the method comprising:
selecting a target power storage device that is one of the plurality of power storage devices;
setting the switching circuits in such a way that other power storage devices of the plurality of power storage devices excluding the target power storage device are electrically connected in series and the target power storage device is electrically separated from the other power storage devices connected in series;
controlling a charge/discharge inspecting device connected to the target power storage device to charge/discharge the target power storage device for measurement;
acquiring measurement data obtained by measuring the target power storage device during the charge/discharge; and
evaluating deterioration of the target power storage device based on the measurement data.
